Europäisches Patentamt

European Patent Office

Office européen des brevets

(19)

(11) Veröffentlichungsnummer: **0 072 523**

**A2**

(12) **EUROPÄISCHE PATENTANMELDUNG**

(21) Anmeldenummer: **82107242.8**

(22) Anmeldetag: **10.08.82**

(51) Int. Cl.³: **H 03 K 17/08**

(30) Priorität: **14.08.81 DE 3132257**

(43) Veröffentlichungstag der Anmeldung:
**23.02.83 Patentblatt 83/8**

(84) Benannte Vertragsstaaten:
**AT BE CH IT LI NL**

(71) Anmelder: **SIEMENS AKTIENGESELLSCHAFT**
**Berlin und München Wittelsbacherplatz 2**
**D-8000 München 2(DE)**

(72) Erfinder: **Hoepfner, Klaus, Ing.(grad.)**
**Mittenwalder Strasse 41**
**D-8000 München 71(DE)**

(72) Erfinder: **Klauck, Bernd, Dipl.-Ing.**
**St. Cajetanstrasse 7**
**D-8000 München 80(DE)**

(54) Schutzschaltung für einen Feldeffekttransistor in einem Laststromkreis.

(57) Die Schutzschaltung verhindert ein kritisches Ansteigen des Laststromes. Sie besteht aus einer parallel zur gesteuerten Strecke des Feldeffekttransistors 15 geschalteten Strommeßschaltung 5,6, deren Ausgang einen ersten Schalter 12 steuert. Der erste Schalter begrenzt die Steuerspannung am Steuereingang des Feldeffekttransistors. Ein weiterer Schalter 13 sperrt den Steuereingang des ersten Schalters, sobald ein Taktimpuls am Eingang 17 der Schaltung anliegt.

EP 0 072 523 A2

SIEMENS AKTIENGESELLSCHAFT          Unser Zeichen

Berlin und München                  81 P 2 0 7 2 E

## Schutzschaltung für einen Feldeffekttransistor

Die Erfindung betrifft eine Schutzschaltung für einen Feldeffekttransistor in einem Laststromkreis.

Bekanntlich weist ein gesteuerter Schalter, wie beispielsweise ein Transistor, einen Steuereingang und eine gesteuerte Strecke auf, die in einem Laststromkreis einer
Schaltung liegen kann. Bei einem Feldeffekttransistor besteht die gesteuerte Strecke aus einem Kanal, welcher von
zwei Isolierschichten begrenzt wird. Beim Anlegen einer
Steuerspannung werden die Isolierschichten verbreitert und
damit der Querschnitt des Kanals verringert. Auf diese
Weise läßt sich der im Kanal fließende Strom steuern. Wenn
sich beide Isolierschichten berühren, ist die gesteuerte
Strecke und damit der Stromfluß unterbrochen. Wird dann
die Steuerspannung weiter erhöht, bildet sich zwischen
beiden Enden der gesteuerten Strecke ein so hohes Potential, daß die Isolierschicht durchschlägt und die gesteuerte
Strecke aufgerissen wird. Der Strom steigt bis zum Kurzschluß
an und der Feldeffekttransistor wird zerstört.

Der Erfindung lag daher die Aufgabe zugrunde, eine Strombegrenzerschaltung der oben genannten Art anzugeben, mit
welcher das Ansteigen des Stromes bis zur Zerstörung verhindert wird.

Diese Aufgabe wird gelöst durch einen steuerbaren ersten
Schalter, dessen gesteuerte Strecke mit dem Steuereingang
des Feldeffekttransistors verbunden ist, und durch eine
Strommeßschaltung, welche parallel zur gesteuerten Strecke

Lg 1 Pe /8.7.81

**0072523**

des Feldeffekttransistors geschaltet ist, und deren Ausgang mit dem Steuereingang des ersten Schalters verbunden ist.

Vorteilhafterweise besteht die Strommeßschaltung aus einem Spannungsteiler. In einer Weiterbildung der Erfindung sind Ansteuerimpulse für den Feldeffekttransistor vorgesehen, und ein zweiter gesteuerter Schalter, dessen gesteuerte Strecke mit dem Steuereingang des ersten Schalters verbunden ist, und an dessen Steuereingang die Ansteuerimpulse anliegen. Weiter ist es zweckmäßig, daß ein dritter steuerbarer Schalter vorgesehen ist, dessen gesteuerte Strecke über eine Impulsformerschaltung mit dem Steuereingang des Feldeffekttransistors verbunden ist und an dessen Steuereingang die Ansteuerimpulse anliegen. Die Weiterbildung der Erfindung ergibt sich aus den Unteransprüchen.

Die Strombegrenzerschaltung verwendet den Durchlaßwiderstand des Feldeffekttransistors in Verbindung mit den Ansteuerimpulsen. Der Durchlaßwiderstand wird als Meßwiderstand für die Strombegrenzung genutzt. Die am Durchlaßwiderstand abfallende Spannung dient als Regelgröße zur Begrenzung des Stromes. Ein Reihenwiderstand zwischen dem Ausgang des Feldeffekttransistors und einem Bezugspotential erübrigt sich. Damit sinkt die Verlustleistung der Schaltung. Die Strombegrenzerschaltung eignet sich auch, um den Strom bei einem temperaturabhängigen Ansteigen zu begrenzen. Gesteuert von den Ansteuerimpulsen ist die Strombegrenzerschaltung nur im eingeschalteten Zustand des Feldeffekttransistors wirksam.

Im folgenden wird die Erfindung anhand eines in einer Figur dargestellten Ausführungsbeispiels weiter beschrieben.

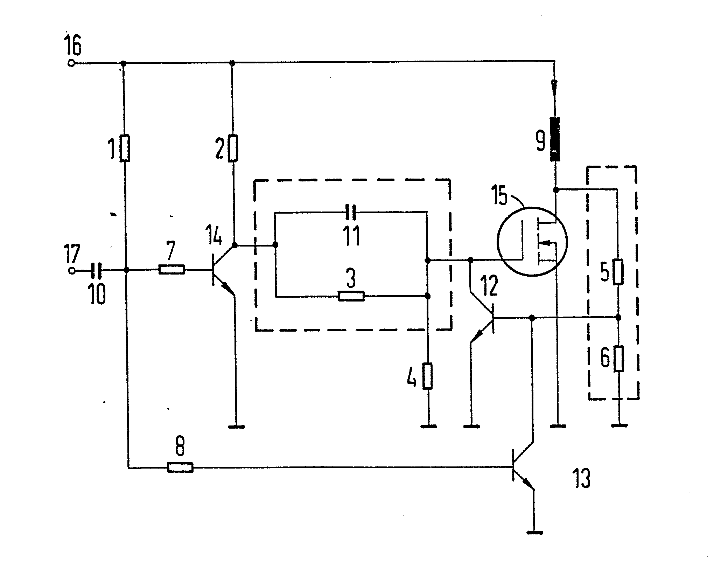

Die Figur zeigt einen MOS-Feldeffekttransistor 15 in Source-Schaltung. Der MOS-Feldeffekttransistor 15 ist im folgenden als MOS-FET bezeichnet. Am Eingang 16 der Schaltung liegt eine Betriebsspannung an. Der Eingang 16 ist über einen Lastwiderstand 9 mit dem Drain-Anschluß des MOS-FET 15 verbunden. Der Source-Anschluß des MOS-FET 15 ist mit einem Bezugspotential verbunden. Die Verbindung zwischen Drain-Anschluß und Source-Anschluß ist als gesteuerte Strecke des MOS-FET 15 bezeichnet. Die Verbindung von Eingang 16 und Bezugspotential über die Last 9 ist Teil des Laststromkreises.

An einem weiteren Eingang 17 der Schaltung liegt ein Ansteuertakt mit rechteckförmigen Ansteuerimpulsen an. Der Eingang 17 ist über die Serienschaltung eines Koppelkondensators 10 und eines Widerstandes 7 mit der Basis eines Transistors (dritter Transistor) 14 verbunden. Der Verbindungspunkt zwischen Koppelkondensator 10 und Widerstand 7 ist über einen Widerstand 1 mit dem Eingang 16 verbunden. Der Kollektor des dritten Transistors ist über einen Widerstand 2 ebenfalls mit dem Eingang 16 verbunden. Außerdem ist er über eine Impulsformerschaltung, welche aus der Parallelschaltung einer Kapazität 11 und eines Widerstandes 3 besteht, mit dem Steuereingang des MOS-FET verbunden. Der Steuereingang ist außerdem über einen Widerstand 4 mit dem Bezugspotential verbunden.

Ein Spannungsteiler 5, 6, bestehend aus zwei Widerständen 5, 6 ist parallel zur gesteuerten Strecke des MOS-FET 15, d.h. zwischen dem Drain- und dem Source-Anschluß, angeordnet. Der Ausgang des Spannungsteilers 5, 6 ist mit der Basis eines Transistors (erster Transistor) 12 verbunden. Die gesteuerte Strecke des ersten Transistors
12 ist mit dem Steuereingang des MOS-FET 15 verbunden.
Der Verbindungspunkt des Koppelkondensators 10 und des
Widerstandes 7 ist über einen Widerstand 8 mit der
Basis eines Transistors (zweiter Transistor) 13 verbunden. Die gesteuerte Strecke des zweiten Transistors 13
ist mit der Basis des ersten Transistors 12 verbunden.
Alle Emitter-Anschlüsse der Transistoren 12, 13, 14
sind mit dem Bezugspotential verbunden. Die Transistoren
12, 13 und 14 sind Beispiele eines gesteuerten Schalters,
wobei der Steuereingang mit dem Basisanschluß identisch
ist. Als gesteuerte Strecke eines Transistors ist die Verbindung zwischen Emitter- und Kollektoranschluß bezeichnet.

Wenn am Eingang 17 negative Ansteuerimpulse anliegen,
wird die gesteuerte Strecke des dritten Transistors 14
hochohmig. Der dritte Transistor 14 sperrt. Über den
hochohmigen Spannungsteiler 2, 4 wird dem Steuereingang
des MOS-FET 15 eine Vorspannung zugeführt. Dadurch wird
die gesteuerte Strecke des MOS-FET 15 niederohmig, und
es fließt ein Strom in der gesteuerten Strecke des MOS-
FET 15. Dadurch sinkt die Spannung an den Widerständen
5, 6. Die Spannung am Verbindungspunkt der beiden Widerstände 5, 6 ist abhängig vom Durchlaßwiderstand
der gesteuerten Strecke des MOS-FET 15, des Stromes
durch die gesteuerte Strecke und vom Teilerverhältnis
des Spannungsteilers. Da der Durchlaßwiderstand fast
linear mit der Temperatur wächst, ist die Spannung auch
ein Maß für die Temperatur des MOS-FET. Der Durchlaßwiderstand dient dann als Meßgröße für die thermische
Begrenzung. Die Spannung am Verbindungspunkt dient als
Regelgröße zum Begrenzen der durch die gesteuerte Strekke des MOS-FET 15 fließenden Stromes. Steigt der Strom,
so steigt auch die Spannung am Spannungsteiler 5, 6. Dadurch wird der erste Transistor 12 angesteuert, und über dessen gesteuerte Strecke die Spannung am Steuereingang des MOS-FET 15 verkleinert. Insbesondere wenn die Last 9 als induktive Last ausgebildet ist, kann der Strom in der gesteuerten Strecke des MOS-FET 15 so hoch ansteigen, daß dieser zerstört wird. Auch eine zu hohe Betriebsspannung kann zur Zerstörung führen.

Liegt am Eingang 17 ein positiver Steuerimpuls an, so wird der dritte Transistor 14 leitend. Die Spannung am Steuereingang des MOS-FET 15 sinkt und die gesteuerte Strecke wird gesperrt. In dieser Sperrphase ist die Spannung am Spannungsteiler annähernd Null, weil der zweite Transistor 13 leitet, und der erste Transistor 12 ist gesperrt.

Besonders in einer Anlaufphase der Schaltungsanordnung, d.h. wenn die Betriebsspannung am Eingang 16 angelegt wird, kann der Fall eintreten, daß der erste Transistor 12 durch die am Spannungsteiler anliegende Betriebsspannung durchgeschaltet wird. Der MOS-FET 15 kann also nicht angesteuert werden. Deshalb ist der zweite Transistor 13 vorgesehen, welcher die Wirkung der Strombegrenzung während der Sperrphase des MOS-FET 15 verhindert. Liegt am Eingang 17 ein Ansteuerimpuls an, so wird der zweite Transistor 13 durchgeschaltet und der erste Transistor 12 gesperrt. Somit ist jederzeit ein Ansteuern des MOS-FET 15 gewährleistet.

Der dritte Transistor 14 dient als Schutz für den Steuereingang des MOS-FET 15. Er verhindert, daß fehlerhafte oder verstümmelte Ansteuerimpulse den MOS-FET 15 ansteuern und Überspannungen zu einer Zerstörung des Steuereingangs führen. Die am Eingang 17 anliegenden Ansteuerimpulse werden durch den dritten Transistor 14

**0072523**

und die beiden Widerstände 2 und 3  mit einem für den Steuereingang des MOS-FET 15  unkritischen Hub versehen. Die Kapazität 11  beeinflußt  die Flankensteilheit.

Fallen die Ansteuerimpulse aus, oder haben sie eine zu geringe Frequenz, was bei induktiver Last 9  zu unzulässigem Stromanstieg führt, sperrt der Transistor 14 den MOS-FET 15  nach der durch den Koppelkondensator 10 und den Widerstand 1  festgelegten Zeitkonstante und setzt eine Nachfolgeschaltung (nicht dargestellt) außer Betrieb.

1 Figur

7 Patentansprüche

Patentansprüche

1. Schutzschaltung für einen Feldeffekttransistor in einem Laststromkreis, g e k e n n z e i c h n e t durch einen steuerbaren ersten Schalter (12), dessen gesteuerte Strecke mit dem Steuereingang des Feldeffekttransistors (15) verbunden ist, und durch eine Strommeßschaltung, welche parallel zur gesteuerten Strecke des Feldeffekttransistors (15) geschaltet ist, und deren Ausgang mit dem Steuereingang des ersten Schalters (12) verbunden ist.

2. Schutzschaltung nach Anspruch 1, d a d u r c h   g e - k e n n z e i c h n e t, daß die Strommeßschaltung aus einem Spannungsteiler (5,6) besteht.

3. Schutzschaltung nach Anspruch 1 oder 2, d a d u r c h   g e k e n n z e i c h n e t, daß Ansteuerimpulse für den Feldeffekttransistor (15) vorgesehen sind, und daß ein zweiter steuerbarer Schalter (13) vorgesehen ist, dessen gesteuerte Strecke mit dem Steuereingang des ersten Schalters (12) verbunden ist, und an dessen Steuereingang die Ansteuerimpulse anliegen.

4. Schutzschaltung nach einem der Ansprüche 1 bis 3, d a d u r c h   g e k e n n z e i c h n e t, daß ein dritter steuerbarer Schalter (14) vorgesehen ist, dessen gesteuerte Strecke über eine Impulsformerschaltung (3, 11) mit dem Steuereingang des Feldeffekttransistors (15) verbunden ist und an dessen Steuereingang die Ansteuerimpulse anliegen.

5. Schutzschaltung nach Anspruch 4, d a d u r c h   g e - k e n n z e i c h n e t, daß die Impulsformerschaltung

(3;11) aus einer Parallelschaltung einer Kapazität (11)
eines Widerstandes (3) besteht.

6. Schutzschaltung nach einem der Ansprüche 1 bis 5,
d a d u r c h   g e k e n n z e i c h n e t, daß der erste
Schalter (12) aus einem ersten Transistor besteht, der
zwischen dem Steuereingang des Feldeffekttransistors (15)
und einem Bezugspotential liegt.

7. Vorrichtung nach einem der Ansprüche 1 bis 6, d a d u r ch
g e k e n n z e i c h n e t, daß der zweite Schalter (13)
aus einem zwischen dem Steuereingang des ersten Schalters
(12) und dem Bezugspotential liegenden zweiten Transistor
besteht.